# DEMANDE DE BREVET EUROPEEN

(11) **EP 2 654 070 A1**
(43) Date de publication de la demande: **23.10.2013**
(21) Numéro de dépôt: 12164326.6
(22) Date de dépôt: 16.04.2012
(51) Int. Cl.: H01J 37/32, C23C 16/509, H01L 21/02

(54) **Réacteur plasma de type capacitif pour le dépôt de films minces**

(71) Demandeur: INDEOtec SA, 2002 Neuchatel 2 (CH)
(72) Inventeur: Jeanneret, Fabrice, 2114 Fleurier (CH); Shojaei, Omid Reza, 1066 Epalinges (CH); Schmitt, Jacques, 45300 Yèvre le Châtel (FR)
(74) Mandataire: P&TS SA (AG, Ltd.)

(57) **Abrégé**

La présente divulgation concerne un réacteur plasma (100) de type capacitif comprenant une enceinte à vide; une première électrode (5) dans l'enceinte à vide; une seconde électrode (6) dans l'enceinte à vide, opposée à la première électrode et espacée de cette dernière d'un espacement (D); une puissance électrique radiofréquence (8) alimentant l'une des électrodes (5, 6), l'autre électrode étant à la masse; les deux électrodes (5, 6) comprenant une région centrale dans laquelle elles sont arrangées de façon substantiellement parallèles et où l'espacement (D) est substantiellement constant; les deux électrodes (5, 6) comprenant en outre un biseau (18) formé par l'espacement (D) entre la première et la seconde électrode (5, 6) diminuant progressivement et symétriquement par rapport à un plan médian (21) aux deux électrodes (5, 6); le biseau (18) comprenant un espace séparatif (29); le biseau (18) et l'espace séparatif (29) s'étendant sur au moins une partie de la périphérie des électrodes. Le réacteur plasma de l'invention permet d'obtenir des dépôts de films minces plus uniformes sur l'ensemble de la surface du substrat.

## Description

### Domaine technique

La présente divulgation concerne un réacteur plasma radiofréquence de type condensateur pour le dépôt de films minces en PECVD permettant la déposition de films uniformes. Plus particulièrement, la présente divulgation concerne la géométrie du réacteur plasma permettant des conditions plasma homogènes.

### Etat de la technique

Les réacteurs plasma de type condensateur comprennent deux électrodes parallèles (Parallel Plate Reactor), utilisés pour le dépôt de films minces en PECVD (Plasma Enhanced Chemical Vapor Deposition). Ce type de réacteur est le plus commun pour le dépôt de divers films (a-Si, µc-Si, SiOx, SiN, µc-C) sur des substrats plans, soit un verre (écrans plats, panneaux solaires), soit des tranches de silicium cristallin (senseurs, couches isolantes ou héterojonctions) ou une feuille souple métallique ou polymère.

Dans ce type de réacteur, le plasma a une épaisseur de gaine typiquement de l'ordre d'une fraction de millimètre à quelques millimètres, et qui reste inférieure à la moitié de l'espace entre les électrodes. Le plasma est souvent affecté par la nucléation de nuages de poudre qui y lévitent sous forme ionisée. Ces poudres résultent d'une nucléation de particules solides dans le gaz moléculaire ionisé. Les poudres se rencontrent dans les plasmas de déposition en particulier ceux qui déposent du silicium (ou un de ses composés), du Germanium, voire du carbone (ou un de ses composés).

Ce type de réacteur présente également une non-uniformité du dépôt qui est induite par les effets de bord. La région centrale d'un condensateur est intrinsèquement uniforme, grâce à la simplicité de sa géométrie. Mais le bord du condensateur crée une discontinuité qui perturbe l'équilibre. De fait les conditions aux bords sont par nécessité différentes de celles de la région centrale. Cette variation induit un changement local du plasma qui peut ensuite s'étendre en partie vers l'intérieur.

Les mécanismes qui définissent le comportement d'un plasma forment une combinaison complexe mêlant électronique des plasmas, chimie des gaz excités, physico-chimie de surface, et dynamique des nuages de poudres ionisées. Il est probablement impossible de concevoir une géométrie de bord qui resterait neutre pour toutes les conditions plasma possibles depuis les plasmas de gravures, électronégatifs et à haute densité électronique jusqu'aux plasmas moléculaires à plus haute pression du PECVD.

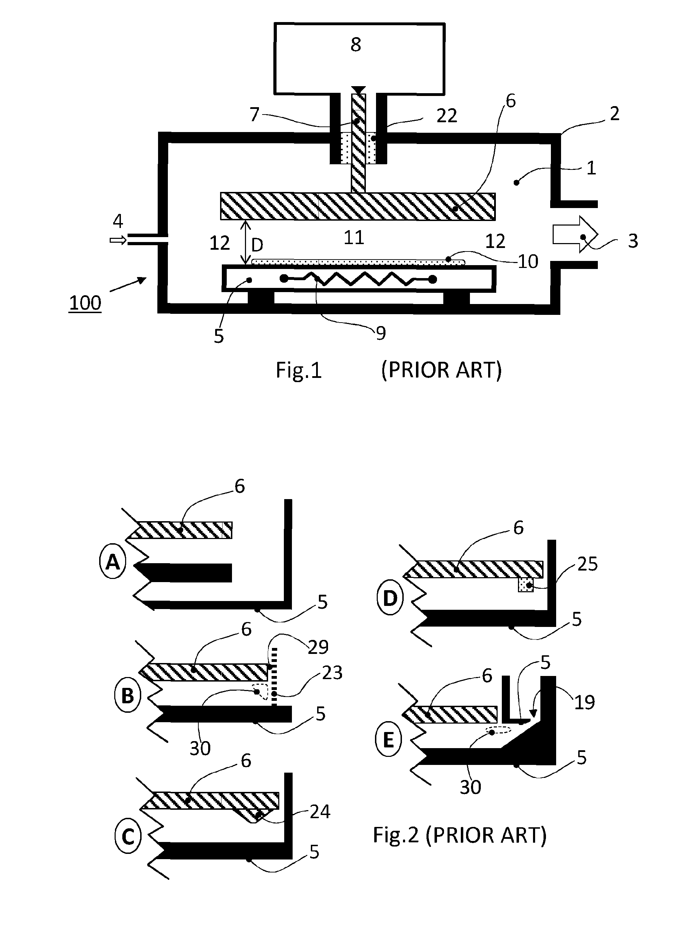

Les premiers réacteurs plasma de type condensateur étaient faits de deux disques plans face à face, isolés au milieu d'une enceinte à vide. Les principaux éléments de ces machines pionnières sont détaillés dans la Fig.1. Un volume d'enceinte 1 est inséré dans une enceinte étanche 2. Des gaz sont pompés par un système de pompage (non représenté) relié à l'enceinte par une ligne 3. Les gaz réactifs pour le dépôt sont injectés par une entrée 4. Le condensateur est formé d'une première électrode 5 à la masse faisant face à une seconde électrode 6 qui est alimentée par une puissance électrique radiofréquence via une ligne coaxiale 7 munie d'un passage étanche 22. Le système d'alimentation radiofréquence 8 est en général un générateur associé à une boîte d'accord. Les radiofréquences utilisées pour les procédés plasma sont en général à 13,56 MHz, mais il y a aujourd'hui une tendance à utiliser des plus hautes fréquences jusqu'à 100-120 MHz. Au moins une des électrodes, en général celle qui porte le ou les substrats, est chauffée à une température contrôlée qui, selon les procédés peut varier entre 120 et 600 °C. Ce maintien en température est obtenu par une résistance 9. Un substrat 10 peut être attaché sur la première électrode 5. On observe que la région centrale 11 du condensateur est naturellement homogène, mais que dans une région périphérique 12, le plasma rencontre des conditions aux limites différentes. Dans le cas du réacteur 100 primitif de la fig.1, le plasma s'ouvre au bord sur un grand volume et des parois lointaines à la masse. Dans ce type de réacteur 100 le plasma tend à "déborder" largement en s'atténuant. Il a aussi tendance à se coupler plus avec la masse sur les bords, provoquant un courant électrique capacitif qui retourne en partie vers le centre 11 du condensateur.

Beaucoup d'approches ont été testées pour limiter les effets de bord. On trouvera dans la Fig. 2 quelques-unes des idées proposées. On retrouve le cas de la Fig. 1 schématisé dans la Fig. 2A. Dans tous ces croquis la seconde électrode RF 6 est représentée hachurée alors que les pièces à la masse 5 sont en noir (les isolants diélectriques quand il y en a sont représentés avec des points). Une des solutions proposée dans le brevet US4633809 est représentée à la Fig. 2B. Elle consiste à placer autour du condensateur une grille 23 proche à la masse. Cette grille stoppe le plasma mais laisse passer les gaz. Cette idée a été déclinée dans beaucoup de versions dans des réacteurs expérimentaux et industriels. On notera qu'au voisinage de la grille 23 le plasma perd sa symétrie électrique et devient plus fortement couplé à la masse. Comme dans toutes les configurations modernes de plasma, l'électrode 6 alimentée en puissance électrique est, à son bord, très rapprochée des parois métalliques à la masse (ici la grille 23). Les deux pièces avec une forte différence de potentiel électrique ne sont pas au contact mais distantes d'un espace séparatif étroit 29. Dans le plasma, vis-à-vis de cette zone de proximité est induite une zone de champ électrique fort, créant une zone de point chaud 30, également appelée "point chaud" dans le présent texte. Dans la figure 2E, la zone de point chaud 30 est représentée par le traitillé.

La Fig. 2C correspond à une géométrie décrite dans le brevet US6391787 pour un réacteur de gravure ionique. Une pièce de biais périphérique 24 réduit l'épaisseur du plasma près des bords. Il semble que l'effet combiné de la chute de pression lié à l'étranglement formé par la pièce de biais 24 se combine avec l'effet d'un espace plus étroit pour le plasma. Le résultat pour un plasma de gravure serait une sorte de neutralisation des effets de bord. On notera qu'au voisinage de ce bord le plasma se retrouve plus couplé à l'électrode RF 6 qu'à la masse, ce qui ne manquera pas de créer une perturbation dans les plasmas de PECVD.

La Fig. 2D illustre une classe de solutions qui utilisent un diélectrique isolant 25 ajouté sur le bord du condensateur. Dans le cas décrit dans le brevet US4367114, le diélectrique isolant 25 prend la forme d'une surépaisseur diélectrique sur l'électrode 6. On notera que cette solution induit elle aussi une dissymétrie au niveau de l'équilibre électrique du potentiel plasma en favorisant le couplage à l'électrode 6. Le cas de deux pièces diélectriques symétriques a aussi été étudié dans la référence 1: "M A LIEBERMANN, A J LICHTENBERG, Sungjin KIM, J T GUDMUNDSSON, D L KEIL and Jisoo KIM, Plasma ignition in a grounded chamber connected to a capacitive discharge, 2006, Plasma Sources Sci. Technol. 15, 276", mais comme elles sont toutes deux attachées à la masse, cette géométrie est aussi inadapté au PECVD parce qu'elle induit une forte dissymétrie électrique dans les régions distales du plasma. Le brevet US6974523, qui revendique une grille assez semblable à celle de la fig. 2B, cite un art antérieur où les bords du condensateur sont fermés par un empilement d'anneaux plats en quartz superposés. Cette solution est symétrique électriquement, mais elle n'a jamais été essayée en PECVD du fait de la fragilité et de la complexité de l'assemblage et aussi parce qu'elle est sans doute incapable d'empêcher le plasma de s'échapper.

La Fig. 2E représente le bord d'un plasma PECVD industriel décrit dans US5582866. On y trouve une fermeture en biais par l'électrode 5 à la masse qui se termine sur une fente de pompage 19. On notera que dans cette géométrie, le bord du condensateur est non-symétrique puisque dominé par la masse. Néanmoins, un mérite de cette géométrie est que le flux de gaz est pincé, la grande vitesse d'évacuation des gaz favorisant l'extraction des poudres. Un point faible vient de la région où les pièces métalliques avec des polarités opposées sont en proximité. Ici un grand champ électrique parallèle à la paroi va exciter un point chaud 30, un plasma très intense avec des effets dommageables tels qu'une grande vitesse de déposition locale qui peut diffuser jusqu'au substrat; une consommation inutile des gaz, et une génération locale de poudre. Dans la réalisation de la fig.2E, le point chaud 30 est proche du bord du substrat et va induire un dépôt plus rapide en périphérie. On notera, bien qu'il ne soit pas représenté dans chaque figure, qu'il y a toujours un point chaud 30 dans le plasma en face de la zone de rapprochement des électrodes soumises à une différence de potentiel électrique radiofréquence.

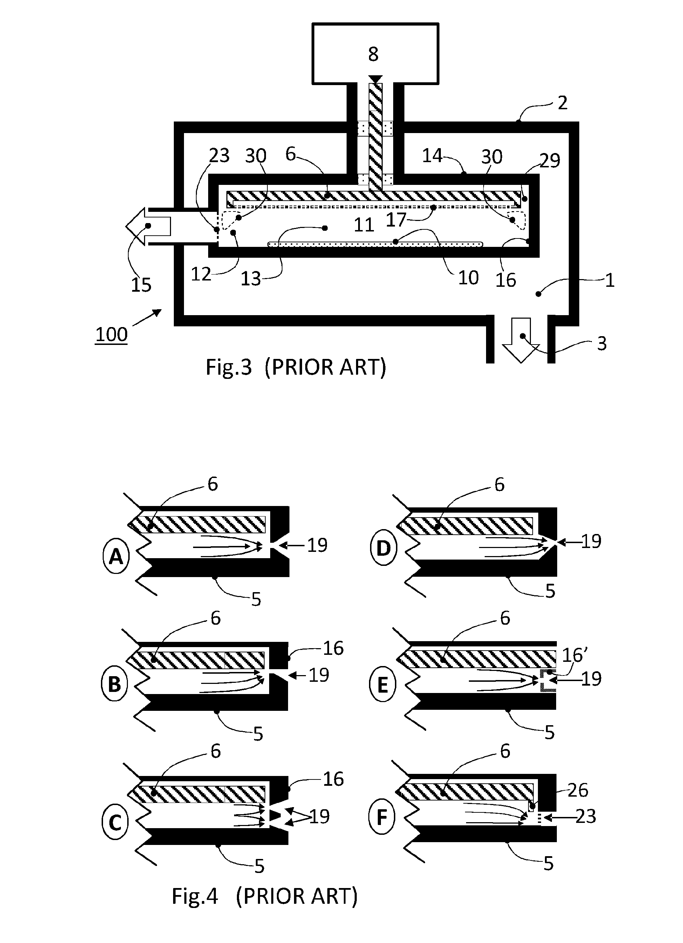

Dans le concept de réacteur 100 décrit dans la Fig. 3, un volume interne 13 réservé à la chimie de dépôt est isolé du volume principal 1 de l'enceinte à vide par une paroi 14 semi-étanche (voir le brevet US4798739) et maintenue isotherme (US4989543) à la température requise par le substrat 10. Une différence de pression entre l'intérieur et l'extérieur du réacteur 100 est maintenue durant le procédé, les gaz réactifs étant évacués par une ligne d'évacuation 15. Comme dans tous les réacteurs modernes les gaz sont injectés par l'intermédiaire de l'électrode, qui fait face au substrat, ayant la forme d'un pommeau de douche 17. La plupart des réacteurs de ce type sont terminés au bord par une grille de pompage verticale 23 dans la région périphérique 12, ou par une paroi latérale 16 à la masse. On notera que si ce système apporte une pureté chimique améliorée, il n'apporte pas de solution à la perte de symétrie du plasma au voisinage des bords. L'espace séparatif 29 est situé dans les coins supérieurs du réacteur à la jonction entre l'électrode 6 et les parois verticales à la masse 16 et 23. Dans le plasma, en face de l'espace séparatif 29, se trouvent les points chauds 30.

La demande de brevet US2001/0003272 décrit divers moyen de contrôler les nuages de poudres dans les plasmas de dépôts (en particulier ceux à base de silane). Une des idées clef est de limiter la densité des nuages de poudres qui tendent à s'accumuler en bord de gaine (à la périphérie du plasma). Pour cela, il convient d'extraire les poudres qui sont piégées dans le plasma par une puissante force électrostatique en utilisant l'"effet de souffle" des gaz sortant de la décharge. La Fig. 4 illustre différentes options décrites dans cette demande de brevet. Plus particulièrement, dans la Fig. 4A, les gaz sont extraits non pas par une grille mais par une fente 19 dans un plan médian du plasma. La fente 19 pince localement le flux de gaz, augmentant ainsi la vitesse locale et augmentant d'autant l'extraction aérodynamique des poudres. Dans la Fig. 4B, la fente d'extraction 19 est déplacée vers le point de jonction de l'électrode RF 6 et la paroi 16 du réacteur 100. Ce positionnement est judicieux car le flux de gaz coïncide avec une zone de surintensité du plasma ou point chaud (zone d'ionisation plus intense dans le plasma). La zone de point chaud a été observée par diffusion Raleigh de lumière laser (référence 2: HOWLING A., HOLLENSTEIN Ch. And PARIS P.-J., Direct visual observation of powder dynamics in RF plasma assisted deposition, Appl. Phys. Lett. 59, 1409 (1991)). Il apparait qu'elle correspond à une zone de création et d'accumulation de poudre au bord des électrodes dans la région périphérique 12, le nuage tendant ensuite à s'étirer vers la région centrale 11 où se trouve le substrat 10. Placer la fente d'extraction 19 au niveau de ce point chaud est donc une bonne stratégie au niveau du contrôle des nuages de poudre. Toutefois on notera que la proposition de la Fig. 4B garde une dissymétrie électrique sur les bords, puisque la paroi 16 est à la masse. Dans la Fig. 4C, on a placé deux fentes d'extraction 19 dans la paroi 16 à la masse, chaque fente 19 étant sensiblement placée au niveau des gaines de chacune des deux électrodes 5, 6. Là encore la géométrie n'est pas symétrique électriquement. La fig.4D décrit une sorte d'entonnoir pour les gaz taillé dans la paroi 16 à la masse du réacteur 100. Cette idée pourrait améliorer l'extraction des poudres mais elle est très dissymétrique au niveau des potentiels. Le cas décrit en Fig. 4E est lui symétrique électriquement. La fente d'extraction 19 est taillée dans une pièce flottante 16' métallique isolée électriquement, point milieu d'un diviseur capacitif entre les deux électrodes 5, 6. Cette géométrie est intéressante mais elle est assez difficile à réaliser pratiquement. Il faut en particulier y adjoindre en aval un dispositif supplémentaire pour éviter que le plasma ne s'étende au-delà de la fente 19. Le dernier schéma, Fig. 4F, réfère à une expérience d'analyse des effets de bord de plasma où il a été démontré qu'en PECVD la perte locale de symétrie induit une perturbation qui s'étend vers l'intérieur du condensateur (référence 3: HOWLING A. et al., Probe measurement of plasma potential non-uniformity due to edge asymmetry in large area radiofrequency reactors; the Telegraph effect, J. App. Phys. 97, 123308 (2005)). En ajoutant une jupe 26 au bord de l'électrode 6 et qui s'étend jusqu'à la mi-distance entre les électrodes 5, 6, on restaure une symétrie et on constate une réduction importante de la perturbation. Le réacteur est terminé au bord par une grille de pompage 23. Toutefois dans cette géométrie le point chaud est au milieu du bord du plasma, assez proche du substrat, et puisqu'on pompe par la grille étendue 23, l'effet de souffle n'est pas concentré sur le point chaud.

Les différentes géométries connues doivent toutes faire face à l'existence d'un point chaud dans la région périphérique 12. Ce point chaud est une source de perturbation par la nucléation de poudre (voir la référence 2), mais aussi par une dissociation locale plus intense des gaz réactifs. Les fragments moléculaires issus de la dissociation vont ensuite diffuser vers les parois. La zone de diffusion s'étend jusqu'au substrat 10 en s'atténuant plus le substrat est loin des bords. On comprendra qu'éloigner le substrat 10 des bords du plasma n'est pas une stratégie acceptable du point de vue industriel car elle implique des équipements plus grands (donc plus coûteux) qui plus est consommant plus d'énergie RF et de gaz réactifs.

### Bref résumé de l'invention

Un but de la présente invention est de proposer un réacteur plasma de type condensateur exempt des limitations des réacteurs connus.

Un autre but de la présente invention est d'obtenir un réacteur plasma de type condensateur permettant de diminuer les effets du point chaud et améliorant l'évacuation des poudres à l'extérieur de la région inter-électrodes.

Selon l'invention, ces buts sont atteints notamment au moyen d'un réacteur plasma de type condensateur, comprenant une enceinte à vide; une première électrode dans l'enceinte à vide faisant face à l'intérieur de l'enceinte à vide; une seconde électrode dans l'enceinte à vide, opposée à la première électrode et espacée de cette dernière d'un espacement; une puissance électrique radiofréquence alimentant l'une des électrodes, l'autre électrode étant à la masse; les deux électrodes comprenant une région centrale dans laquelle elles sont arrangées de façon substantiellement parallèles et où l'espacement est substantiellement constant; les deux électrodes comprenant en outre un biseau formé par l'espacement entre la première et la seconde électrode diminuant progressivement et symétriquement par rapport à un plan médian aux deux électrodes; le biseau comprenant un espace séparatif; le biseau et l'espace séparatif s'étendant sur au moins une partie de la périphérie des électrodes.

Dans un mode de réalisation, l'angle formé entre chacune des électrodes et le plan médian au niveau de l'espace séparatif peut être égal ou inférieur à 60°. L'angle (α) peut également être compris entre 15° et 60°, ou encore entre 20° et 60°. Préférablement, l'angle (α) peut être compris entre 30° et 60°, ou encore entre 30° et 45°

Dans un autre mode de réalisation, les deux électrodes peuvent former un biseau convergeant vers l'espace séparatif, dans la région périphérique. Chacune des électrodes peuvent également comprendre un profil arrondi convergeant vers l'espace séparatif.

Encore dans un autre mode de réalisation, l'espace séparatif a une largeur pouvant correspondre à deux fois l'épaisseur de gaine, ou comprise entre 1 mm et 3 mm.

Encore dans un autre mode de réalisation, le réacteur peut également comprendre un canal d'évacuation en communication fluidique avec l'espace séparatif, le canal pouvant être connecté à un dispositif de pompage, de façon à permettre l'évacuation des gaz réactifs du plasma vers l'extérieur de l'enceinte. Le canal d'évacuation peut également être en communication fluidique avec une ouverture dans une paroi à la masse du réacteur; l'ouverture pouvant être préférablement placée au regard et en prolongement de l'espace séparatif. Le canal d'évacuation peut s'étendre sur au moins une partie de la périphérie des électrodes.

Encore dans un autre mode de réalisation, le réacteur peut comprendre un substrat supporté par l'une des électrodes dans la région centrale. Le réacteur peut comprendre en outre des moyens pour l'ouverture du réacteur au niveau du plan médian et pour abaisser l'électrode supportant le substrat; de façon à introduire et retirer le substrat lorsque le réacteur est ouvert et l'électrode abaissée. L'électrode supportant le substrat peut comprendre une portion mobile dans la région centrale, ladite portion mobile pouvant être abaissée de sorte à introduire et retirer le substrat.

Cette solution présente notamment l'avantage par rapport à l'art antérieur d'obtenir des propriétés du plasma plus homogènes sur l'ensemble de la surface du substrat et donc, d'obtenir des dépôts PECVD plus uniformes sur l'ensemble de la surface du substrat.

### Brève description des figures

Des exemples de mise en oeuvre de l'invention sont indiqués dans la description illustrée par les figures annexées dans lesquelles :
la figure 1 illustre schématiquement un réacteur plasma de type condensateur, selon l'état de la technique;
les figures 2A à 2E représentent différentes géométrie du bord du réacteur plasma, selon l'état de la technique;
la figure 3 illustre une configuration alternative du réacteur plasma, selon l'état de la technique;
les figures 4A à 4F représentent différentes géométries du bord du réacteur plasma de la figure 3, selon l'état de la technique;
les figures 5 à 7 représentent schématiquement différentes géométries de bord d'un réacteur plasma PECVD selon des modes de réalisation.

### Exemple(s) de mode de réalisation de l'invention

Le réacteur plasma divulgué ici a déjà été décrit ci-dessus et est illustré dans les figures 1 et 3. Il comprend typiquement une enceinte à vide 2, une première électrode 5 dans l'enceinte à vide 2 faisant face à l'intérieur de l'enceinte à vide 2, et étant couplée à une masse électrique, et une seconde électrode 6 dans l'enceinte à vide 2, opposée à la première électrode 5 et espacée de cette dernière d'un espacement D. Le réacteur 100 comprend également une puissance électrique radiofréquence 8 alimentant la seconde électrode 6. Les première et seconde électrodes 5, 6 comprennent une région centrale 11 dans laquelle les électrodes 5, 6 sont arrangées de façon substantiellement parallèles et où l'espacement D est substantiellement constant. L'électrode à la masse ainsi que l'électrode alimentée par la radiofréquence peut être indifféremment, respectivement, la première électrode 5 ou la seconde électrode 6. Le réacteur plasma peut également comporter un substrat 10 supporté par l'une ou l'autre des électrodes 5, 6, dans la région centrale 11.

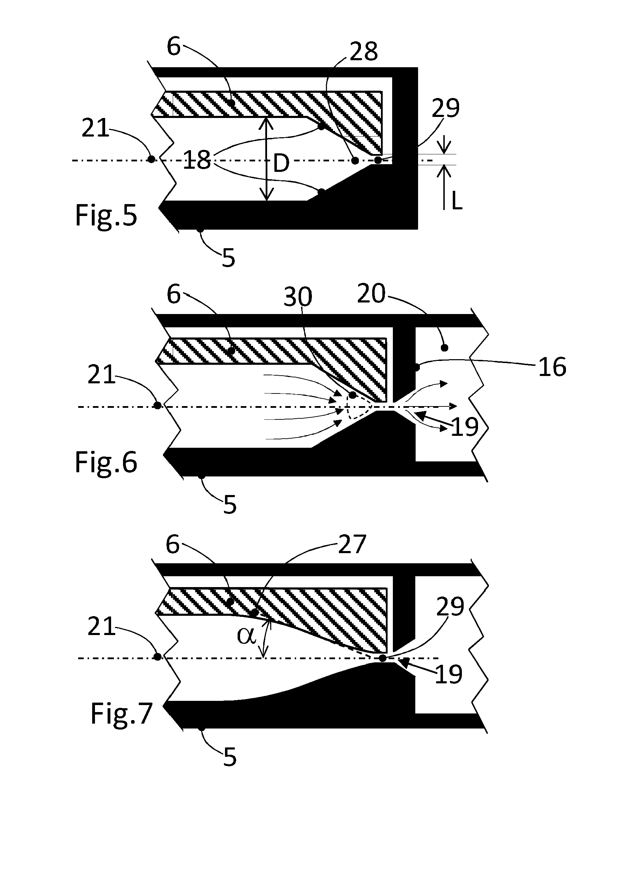

La Fig. 5 représente une vue en coupe du bord du réacteur plasma 100, ou région périphérique 12 du réacteur plasma 100, selon un mode de réalisation. Dans la région périphérique 12, l'espacement D entre la première et la seconde électrode 5, 6 diminue progressivement et de façon symétrique par rapport à un plan médian 21 aux deux électrodes 5, 6, formant ainsi un biseau 18. Dans l'exemple de la Fig. 5, le profil de chacune des électrodes 5, 6 comprend une surépaisseur formant le biseau 18. La forme de la surépaisseur 18 est symétrique par rapport au plan médian 21. Le biseau 18 comprend un espace séparatif 29 de largeur L. La largeur L de l'espace séparatif 29 est préférablement inférieure à une valeur pour laquelle l'allumage d'un plasma est impossible. Par exemple, dans le cas des plasmas PECVD conventionnels, la largeur L est de l'ordre de 2 mm, voir jusqu'à 3 mm, par exemple dans le cas de plasmas de faible densité. D'autre part, la largeur L ne doit pas excéder deux fois l'épaisseur de gaine (zone sans électrons aux limites d'un plasma). Au-dessous de cette dernière valeur de largeur L, le plasma ne pénètre pas dans l'espace séparatif 29. Cependant, la largeur L ne devrait pas être trop étroite de façon à éviter d'induire un très fort court-circuit capacitif pour la puissance RF, et aussi pour éviter que des arcs électriques soient induits par le trop fort champ électrique local dans l'espace séparatif 29. Un bon compromis est une largeur L n'étant pas au-dessous de 1 mm. De façon préférée, la largeur L est comprise entre 1 mm et 3 mm. Le biseau 18 et l'espace séparatif 29 s'étendent sur au moins une partie de la périphérie des électrodes 5, 6. De façon préférée, le biseau 18 et l'espace séparatif 29 s'étendent sur toute la périphérie des électrodes 5, 6, de sorte à obtenir des propriétés du plasma plus homogènes sur l'ensemble de la surface du substrat 10 tout en conservant les dimensions modestes du réacteur 100. Le biseau 18 et l'espace séparatif 29 peuvent cependant n'être compris que sur une partie de périphérie des électrodes 5, 6, par exemple dans le cas d'une géométrie rectangulaire du réacteur 100. Dans ce cas, les côtés du réacteur où le biseau 18 et l'espace séparatif 29 ne sont pas présent à la périphérie des électrodes 5, 6 devront être plus éloignés des électrodes 5, 6, de manière à conserver l'homogénéité des propriétés du plasma sur le substrat 10. Des entretoises en céramique (non représentées) peuvent être disposées au niveau de l'espace séparatif 29, à la fois pour maintenir mécaniquement les pièces 5 et 6 et assurer la précision dimensionnelle de l'espace séparatif 29.

La Fig. 6 représente une vue en coupe d'une région périphérique 12 du réacteur plasma 100, selon un autre mode de réalisation. Dans l'exemple de la Fig. 6, le réacteur 100 comprend en outre un canal d'évacuation 20 en communication fluidique avec une ouverture, ou fente de pompage 19, pratiquée dans une paroi latérale 16 à la masse du réacteur 100. La fente 19 est préférablement placée au regard et en prolongement de l'espace séparatif 29. Le canal d'évacuation 20 peut être connecté à un dispositif de pompage (non représenté) de façon à permettre l'évacuation des gaz réactifs du plasma vers l'extérieur de l'enceinte 2. Le dispositif de pompage peut être arrangé de telle sorte à ce que l'évacuation des poudres se fasse essentiellement sur toute la périphérie des électrodes 5, 6 (par exemple, lorsque le biseau 18 et l'espace séparatif 29 s'étendent sur toute la périphérie des électrodes 5, 6), ou encore sur une portion de la périphérie des électrodes 5, 6. Avantageusement, le dispositif de pompage est arrangé pour évacuer les poudres de façon sensiblement égale le long de la périphérie des électrodes 5, 6. A cette fin, le canal d'évacuation 20 et la fente de pompage 19 peut s'étendre sur toute la périphérie des électrodes 5, 6. Dans le cas d'un réacteur destiné à traiter des substrats 10 rectangulaires, les électrodes 5, 6 du condensateur à plasma peuvent être de forme sensiblement rectangulaire. Le dispositif de pompage peut alors être arrangé pour évacuer les poudres sur au moins l'un des côté des électrodes 5, 6 rectangulaires, ou encore sur deux côtés opposés ou encore sur les quatre côtés. Dans une variante non représentée du mode de réalisation, les électrodes 5, 6 font office de paroi latérale de sorte que la fente 19 est formée que par le seul espace séparatif 29. Dans cette configuration, le canal d'évacuation 20 est en communication fluidique directement avec l'espace séparatif 29.

Encore dans un autre mode de réalisation représenté à la Fig. 7, chacune des électrodes 5, 6 comprend une surépaisseur 18 de profil arrondi. En particulier, la surépaisseur 18 comporte un arrondi, au niveau de la transition entre la région centrale 11 et la région périphérique 12, voire même aussi au niveau du raccordement avec l'espace séparatif 29. La forme de la surépaisseur 18 est symétrique par rapport au plan médian 21.

De façon préférée, l'angle α formé entre le plan médian 21 et une tangente 27 au profil de l'une des électrodes 5, 6 au niveau de l'espace séparatif 29, doit rester inférieur à 60°. L'angle α peut être compris entre 15° et 60° ou encore compris entre 20° et 60°. Une petite valeur de l'angle produira un biseau 18 plus long dans la région périphérique qu'une plus grande valeur de l'angle, et donc un réacteur de plus grandes dimensions. De façon préférée, l'angle α est compris entre 30° et 60°, et de façon encore préférée, l'angle α est compris entre 30° et 45°.

La configuration du réacteur 100 selon des modes de réalisation de l'invention permet d'obtenir des propriétés du plasma plus homogènes sur l'ensemble de la surface du substrat 10 que dans les réacteurs plasma connus. Les dépôts PECVD déposés dans un tel réacteur plasma seront donc également plus uniformes sur la surface du substrat 10 pour l'espace paramétrique le plus grand possible en matière de conditions de procédé: pression, débit, composition des gaz, température, puissance RF et fréquence de cette même RF.

En effet, dans une telle configuration du réacteur 100, le plasma reste à un potentiel plasma radiofréquence qui est un point milieu entre les tensions des électrodes 5, 6 opposées. Il est ainsi possible d'éviter d'induire un courant de radiofréquence radial et horizontal dans la région périphérique 12 qui pourrait y injecter par chauffage ohmique de la puissance électrique. D'autre part, les poudres piégées dans le puits électrostatique qu'est le plasma s'accumulent en bord de gaine. Elles se déplacent facilement en glissant le long des gaines. Dans la configuration du réacteur 100 de l'invention, les poudres peuvent suivre leur piège jusque dans une région distale 28 située au fond du biseau 18. Les poudres seront localisées à proximité de l'ouverture 19 et seront naturellement poussées par la force aérodynamique du gaz en mouvement. Dans la région distale 28 qui limite le plasma, la vitesse du flux de gaz est renforcée par l'effet de pincement de la veine de gaz par les biseaux 18, les poudres sont poussées vers la limite du plasma dans le plan médian 21, précisément là où la vitesse du gaz est maximale. La force aérodynamique devient alors suffisante pour faire sortir les poudres par l'espace séparatif 29 et l'ouverture 19, et les évacuer vers le dispositif de pompage.

Enfin, comme illustré dans la fig.6, le point chaud 30, également localisé dans la région distale 28, n'est pas supprimé, mais ses effets se voient atténués. Les lignes de force électrique (non représentées) sont d'abord perpendiculaires aux gaines (zones relativement inactives parce que sans électron), puis les lignes de champ se rejoignent dans le plasma au niveau du point chaud en faisant un parcours parallèle au bord de gaine. Quand le point chaud 30 est localisé dans la région distale 28, le parcours parallèle du champ électrique est plus court que dans le cas de deux électrodes alignées dans le même plan. Le point chaud 30 sera donc moins grand en volume, mais il restera actif. Vient s'ajouter alors un autre effet favorable lié à la diffusion de l'excès des fragments moléculaires créés dans le point chaud 30. La source est quasi ponctuelle, les radicaux doivent diffuser depuis la pointe d'un coin formé de parois recombinantes. On comprend assez facilement que du fait de l'absorption par les parois proches de l'angle α, les radicaux issus du point chaud ont beaucoup moins de chance de se propager jusqu'à la région centrale 11 où se trouve le substrat 10.

La configuration du réacteur plasma PECVD 100 selon l'invention peut être combinée avec toutes les autres améliorations connues en matière d'ingénierie des réacteurs. On citera en particulier le principe de la Plasma Box® déjà cité dans US4798739 et US4989543. Essentiellement les prescriptions correspondantes sont les suivantes
le réacteur 100 doit être conçu comme une boîte semi-étanche vis-à-vis du vide extérieur;
l'ouverture d'extraction 19 doit déboucher dans un canal (par exemple le canal 20) partie intégrante du réacteur 100;
la ligne de pompage 15 des gaz réactif doit être indépendante, elle aussi semi-étanche;
l'ensemble du réacteur 100 doit être isotherme à la température du substrat 10; et
le réacteur 100 doit s'ouvrir pour le chargement par un moyen qui se referme de manière semi-étanche.

Une autre prescription indispensable dans le design d'un réacteur PECVD concerne les matériaux de construction. Les réacteurs qui déposent de films à base de silicium s'encrassent et doivent être régulièrement nettoyés. On utilise pour cela un procédé plasma à base de fluor qui va transformer les dépôts en gaz qui seront pompés. Toutefois ce procédé de gravure est extrêmement corrosif et implique un cahier des charges extrêmement difficile sur les matériaux de construction des réacteurs. Ce cahier des charges est connu des hommes de l'art et les réacteurs industriels utilisés par l'industrie des écrans plats et des cellules solaires en film mince respectent ce cahier des charges. Bon-an, mal an les seuls métaux possibles sont certains alliages d'aluminium, et les isolants sont quelques céramiques réfractaires. Ce cahier des charges peut être considéré comme un élément de l'ingénierie qu'il faut respecter en intégrant la configuration du réacteur plasma 100 selon l'invention.

Un réacteur industriel doit permettre le chargement/déchargement du/des substrats 10 par des moyens automatiques. Le réacteur semi-étanche doit donc s'ouvrir et le/les substrats 10 doivent être soulevés de l'électrode 5, 6 sur laquelle il/ils sont posés. Un bras articulé (non représenté) peut alors emporter le/les substrats revêtus d'un film et les remplacer par un/des nouveaux substrats. La configuration du réacteur plasma 100 selon l'invention introduit une légère complexité à ce niveau. En effet, les électrodes 5, 6 ont une surépaisseur 18 qui fera obstacle à l'approche du bras d'un robot qui doit se glisser sous le/les substrats 10 pour le chargement/déchargement.

Dans un mode de réalisation non représenté, le réacteur plasma 100 est arrangé de façon à s'ouvrir au niveau du plan médian 21, par exemple, en abaissant l'électrode 5, 6 supportant le substrat 10, et en soulevant simultanément le substrat 10 sensiblement plus haut que la hauteur de la surépaisseur 18.
Dans un autre mode de réalisation également non représenté, l'électrode 5, 6 supportant le substrat 10 comprend une portion mobile dans la région centrale 11, ladite portion mobile pouvant être abaissée de sorte à introduire et retirer le substrat 10.

### Numéros de référence employés sur les figures

- 1: volume d'enceinte
- 2: enceinte à vide
- 3: ligne de pompage de l'enceinte
- 4: entrée des gaz réactifs
- 5: première électrode
- 6: seconde électrode
- 7: ligne coaxiale de puissance RF
- 8: système d'alimentation radiofréquence
- 9: résistance (élément chauffant)
- 10: substrat
- 11: région centrale
- 12: région périphérique
- 13: volume interne
- 14: paroi semi-étanche
- 15: ligne d'évacuation
- 16: paroi latérale
- 16': partie flottante
- 17: électrode avec alimentation en gaz réactifs
- 18: surépaisseur
- 19: fente, ouverture de pompage
- 20: canal d'évacuation
- 21: plan médian
- 22: passage étanche
- 23: grille
- 24: pièce de biais périphérique
- 25: diélectrique isolant
- 26: jupe
- 27: tangente
- 28: région distale
- 29: espace séparatif
- 30: zone de point chaud
- 100: réacteur plasma
- α: angle
- D: distance
- L: largeur

## Revendications

1. Réacteur plasma (100) de type condensateur, comprenant une enceinte à vide (2);
une première électrode (5) dans l'enceinte à vide (2) faisant face à l'intérieur de l'enceinte à vide (2);
une seconde électrode (6) dans l'enceinte à vide (2), opposée à la première électrode (5) et espacée de cette dernière d'un espacement (D);
une puissance électrique radiofréquence (8) alimentant l'une des électrodes (5, 6), l'autre électrode étant à la masse;
les deux électrodes (5, 6) comprenant une région centrale (11) dans laquelle elles sont arrangées de façon substantiellement parallèles et où l'espacement (D) est substantiellement constant; **caractérisé en ce que**
les deux électrodes (5, 6) comprenant en outre un biseau (18) formé par l'espacement (D) entre la première et la seconde électrode (5, 6) diminuant progressivement et symétriquement par rapport à un plan médian (21) aux deux électrodes (5, 6); et **en ce que**
le biseau (18) comprenant un espace séparatif (29); le biseau (18) et l'espace séparatif (29) s'étendant sur au moins une partie de la périphérie des électrodes (5, 6).

2. Réacteur plasma (100) selon la revendication 1, dans lequel l'angle (α) formé entre chacune des électrodes (5, 6) et le plan médian au niveau de l'espace séparatif (29) est égal ou inférieur à 60°.

3. Réacteur plasma (100) selon la revendication 2, dans lequel l'angle (α) est compris entre 15° et 60° ou entre 20° et 60°.

4. Réacteur plasma (100) selon la revendication 2, dans lequel l'angle (α) est compris entre 30° et 60°, mais préférablement entre 30° et 45°.

5. Réacteur plasma (100) selon l'une des revendications de 1 à 4, dans lequel
dans région périphérique (12), les deux électrodes (5, 6) forment un biseau (18) convergeant vers l'espace séparatif (29).

6. Réacteur plasma (100) selon l'une des revendications de 1 à 4, dans lequel
dans région périphérique (12), chacune des électrodes (5, 6) comprennent un profil arrondi convergeant vers l'espace séparatif (29).

7. Réacteur plasma (100) selon l'une des revendications 1 à 6, dans lequel
l'espace séparatif (29) a une largeur (L) correspondant à deux fois l'épaisseur de gaine.

8. Réacteur plasma (100) selon l'une des revendications 1 à 6, dans lequel
l'espace séparatif (29) a une largeur (L) comprise entre 1 mm et 3 mm.

9. Réacteur plasma (100) selon l'une des revendications 1 à 8, comprenant en outre un canal d'évacuation (20) en communication fluidique avec l'espace séparatif (29), le canal (20) pouvant être connecté à un dispositif de pompage, de façon à permettre l'évacuation des gaz réactifs du plasma vers l'extérieur de l'enceinte (2).

10. Réacteur plasma (100) selon la revendication 9, dans lequel canal d'évacuation (20) est en outre en communication fluidique avec une ouverture (19) dans une paroi (16) à la masse du réacteur (100).

11. Réacteur plasma (100) selon la revendication 10, dans lequel l'ouverture (19) est placée au regard et en prolongement de l'espace séparatif (29).

12. Réacteur plasma (100) selon l'une des revendications 9 ou 11, dans lequel
le canal d'évacuation (20) s'étend sur au moins une partie de la périphérie des électrodes (5, 6).

13. Réacteur plasma (100) selon l'une des revendications 1 à 12, comprenant en outre un substrat (10) supporté par l'une des électrodes (5, 6), dans la région centrale (11).

14. Réacteur plasma (100) selon la revendication 13,
comprenant en outre des moyens pour l'ouverture du réacteur (100) au niveau du plan médian (21) et pour abaisser l'électrode (5, 6) supportant le substrat (10); de façon à introduire et retirer le substrat (10) lorsque le réacteur est ouvert et l'électrode (5, 6) abaissée.

15. Réacteur plasma (100) selon la revendication 13, dans lequel l'électrode (5, 6) supportant le substrat (10) comprend une portion mobile dans la région centrale (11), ladite portion mobile pouvant être abaissée de sorte à introduire et retirer le substrat (10).
